(19) **Europäisches Patentamt / European Patent Office / Office européen des brevets**

(11) **EP 2 093 615 A1**

(12) # DEMANDE DE BREVET EUROPEEN

(43) Date de publication:
  **26.08.2009 Bulletin 2009/35**

(51) Int Cl.:
  *G03F 7/20* (2006.01)   *G03F 7/09* (2006.01)

(21) Numéro de dépôt: **09151389.5**

(22) Date de dépôt: **27.01.2009**

(84) Etats contractants désignés:
  **AT BE BG CH CY CZ DE DK EE ES FI FR GB GR HR HU IE IS IT LI LT LU LV MC MK MT NL NO PL PT RO SE SI SK TR**
  Etats d'extension désignés:
  **AL BA RS**

(30) Priorité: **19.02.2008 FR 0800884**

(71) Demandeur: **Commissariat à l'Energie Atomique Bâtiment D "Le Ponant" 25 rue Leblanc 75015 Paris (FR)**

(72) Inventeur: **Imbert, Jean-Louis 38170, Seyssinet (FR)**

(74) Mandataire: **Guérin, Michel et al Marks & Clerk France Conseils en Propriété Industrielle Immeuble " Visium " 22, avenue Aristide Briand 94117 Arcueil Cedex (FR)**

(54) **Procédé de photolithographie ultraviolette à immersion**

(57)   L'invention concerne la photolithographie ultraviolette à 193 nanomètres ou 157 nanomètres.

Pour pousser au maximum l'obtention de résolutions élevées, on utilise des optiques à très forte ouverture numérique, mais on ne dispose pas de résines photosensibles d'indice suffisant pour profiter au mieux de cette ouverture numérique élevée. On propose d'utiliser des résines (PR) ordinaires mais en épaisseur tellement faible qu'elles seront exposées localement par des ondes évanescentes en cas de réflexion totale pour les rayons d'incidence très élevée, et ceci malgré la présence d'un liquide d'immersion (LQ) entre l'optique de projection (OL) et la résine photosensible (PR).

OL
PR → LQ
M1

**3b**

# Fig. 3

## Description

L'invention concerne la photolithographie à très haute résolution.

Actuellement, pour obtenir des motifs de dessins extrêmement étroits, notamment pour la réalisation de circuits électroniques ou optiques, on utilise des machines de photolithographie fonctionnant à des longueurs d'onde ultra-violettes, classiquement 193 nanomètres, ou même 157 nanomètres.

Des tentatives pour utiliser des longueurs d'onde beaucoup plus courtes et permettant donc des motifs encore plus petits ont été faites : la longueur d'onde envisagée est de 13,6 nanomètres (extrême ultra violet) mais les procédés de fabrication de masques sont beaucoup plus complexes.

On cherche donc à pousser au maximum la recherche de résolution élevée avec des longueurs d'onde ultraviolettes classiques et notamment une longueur d'onde de 193 nanomètres (obtenue par un laser excimère au fluorure d'argon).

La limite de résolution optique est définie par une quantité d donnée par la formule $d = k.\lambda/NA$, où $\lambda$ est la longueur d'onde, NA l'ouverture numérique (en anglais "numerical aperture"), et k est un facteur correctif proche de 1 si on ne prend pas en compte des artifices de procédés d'exposition particuliers et pouvant descendre à 0,3 ou même au-dessous si on prend en compte de tels artifices. L'ouverture numérique NA est égale à $n.\sin\theta_m$, où n est l'indice optique du dernier milieu traversé et $\theta_m$ l'angle le plus extrême que peut délivrer le système optique.

Un moyen pour améliorer la résolution (c'est-à-dire diminuer la quantité d) consiste donc à augmenter l'ouverture numérique NA. Mais augmenter l'ouverture numérique pose un problème lorsque l'optique est située dans l'air, c'est-à-dire lorsqu'une couche d'air est interposée entre l'optique et la résine photolithographique qu'on cherche à exposer pour définir un motif à graver. En effet, si l'ouverture numérique est supérieure à 1, l'interface entre le verre de l'optique (ou tout autre matériau transparent) et l'air tend à empêcher la sortie des rayons de forte incidence de la dernière lentille de l'optique vers l'air puis vers la résine.

On peut alors mettre la lentille de sortie du système optique en contact direct avec une résine photolithographique d'indice supérieur ou égal à l'ouverture numérique de l'optique. Dans ce cas, les rayons lumineux d'incidence élevée continuent à sortir de l'optique et à pénétrer dans la résine. Mais on peut comprendre que la mise en contact direct de l'optique avec la résine pose des problèmes s'il s'agit de faire de la photolithographie industrielle : on peut difficilement mettre en contact des surfaces importantes, et on risque de détériorer soit la couche de résine soit même la surface de la dernière lentille de l'optique.

C'est pourquoi on a imaginé dans l'art antérieur d'interposer un liquide, dit liquide d'immersion, entre la lentille et la résine photolithographique à exposer. Pour que les rayons lumineux d'incidence élevée puissent sortir de l'optique et pénétrer dans la résine pour l'exposer, il faut non seulement que ce liquide d'immersion soit transparent pour la longueur d'onde utilisée, mais aussi qu'il ait, pour cette longueur d'onde, un indice de réfraction supérieur à la valeur de l'ouverture numérique de l'optique. Si l'indice de réfraction du liquide d'immersion était plus faible que l'ouverture numérique de l'optique, les rayons d'incidence élevée ne sortiraient pas de la dernière lentille. L'indice de la résine également doit être supérieur à l'ouverture numérique.

Des essais ont donc été faits dans l'art antérieur, pour une longueur d'onde de 193nm ou 157 nm, avec des optiques d'ouvertures numériques de 1,3 environ utilisant de la silice, un fluide d'immersion qui était au départ de l'eau mais qu'on a essayé de remplacer par des liquides d'indices de 1,54 à 1,60 environ, et une résine photosensible d'indice le plus élevé possible, pouvant aller de 1,6 à 1,75.

Si cependant on veut améliorer encore la résolution, il faut augmenter l'ouverture numérique de l'optique, notamment en utilisant des matériaux de lentille d'indice très élevé (par exemple supérieur à 2 pour obtenir une ouverture numérique supérieur à 1,7) ; on se heurte alors au fait qu'il faut un liquide d'immersion et une résine photosensible d'indices supérieurs à 1,7.

Il est très difficile cependant de trouver des résines photosensibles d'indice aussi élevé.

C'est pourquoi l'invention propose d'utiliser un procédé de photolithographie dans lequel on utilise effectivement un liquide d'immersion transparent d'indice élevé pour éviter que la résine soit en contact direct avec l'optique et pour éviter que l'optique soit dans l'air ou dans l'eau (indice insuffisant), mais dans lequel on prévoit que la résine photolithographique a un indice inférieur à celui du liquide d'immersion et une très faible épaisseur, de sorte que, pour les rayons de forte incidence, la résine est exposée dans toute son épaisseur non pas par les rayons réfractés dans la résine mais par les ondes évanescentes présentes à l'interface, là où ces rayons de forte incidence subissent une réflexion totale en raison de leur incidence et du rapport entre les indices du liquide et de la résine.

Par les mots "résine photolithographique", on entend la résine proprement dite ou la résine recouverte d'une fine pellicule de protection appelée en anglais "top coat" lorsque cette fine pellicule existe.

L'épaisseur de résine est alors comprise de préférence entre 0,1 et 0,5 fois la longueur d'onde d'exposition.

Ainsi, l'invention propose un procédé de photolithographie pour réaliser un motif gravé dans une couche déposée sur un support, comprenant l'exposition d'une résine photosensible d'indice de réfraction inférieur ou égal à 1,7 par un faisceau de lumière ultraviolette à travers une optique de projection à forte ouverture numérique (supérieure ou égale à 1,7), cette optique comportant une lentille de projection solide à fort indice de réfraction (de préférence supérieur à 1,7), caractérisé en ce qu'on interpose entre la lentille et la résine photosensible une couche de liquide d'immersion transparente à la longueur d'onde utilisée, dont l'indice de réfraction pour cette longueur d'onde est supérieur ou égal à l'ouverture numérique de l'optique, et en ce que l'indice du liquide d'immersion est supérieur à celui de la résine et l'épaisseur de la résine est comprise entre environ 0,1 et 0,5 fois la longueur d'onde du faisceau d'exposition.

Sur une épaisseur aussi faible, les ondes évanescentes pour les rayons les plus extrêmes (compte-tenu de la valeur de l'ouverture numérique de l'optique) sont présentes dans la résine et exposent celle-ci.

Ainsi, par ce procédé on n'est pas obligé de mettre au point des résines d'indice extrêmement élevé, et on n'est pas obligé non plus de mettre en contact direct une lentille et la résine, ce qui risquerait de dégrader l'une ou l'autre.

D'autres caractéristiques et avantages de l'invention apparaîtront à la lecture de la description détaillée qui suit et qui est faite en référence aux dessins annexés dans lesquels :

- la figure 1 représente le principe général du procédé de photolithographie selon l'invention ;
- la figure 2 représente l'action générale d'un rayon lumineux sur une résine photosensible lorsque l'incidence de ce rayon est inférieure à l'incidence de réflexion totale (2a) et lorsque l'incidence est supérieure à l'incidence de réflexion totale (2b) ;
- la figure 3 représente l'action d'un rayon lumineux sur une résine photosensible de très faible épaisseur lorsque l'incidence est inférieure à l'incidence de réflexion (3a) et lorsque l'incidence est supérieure à l'incidence de réflexion totale (3b).

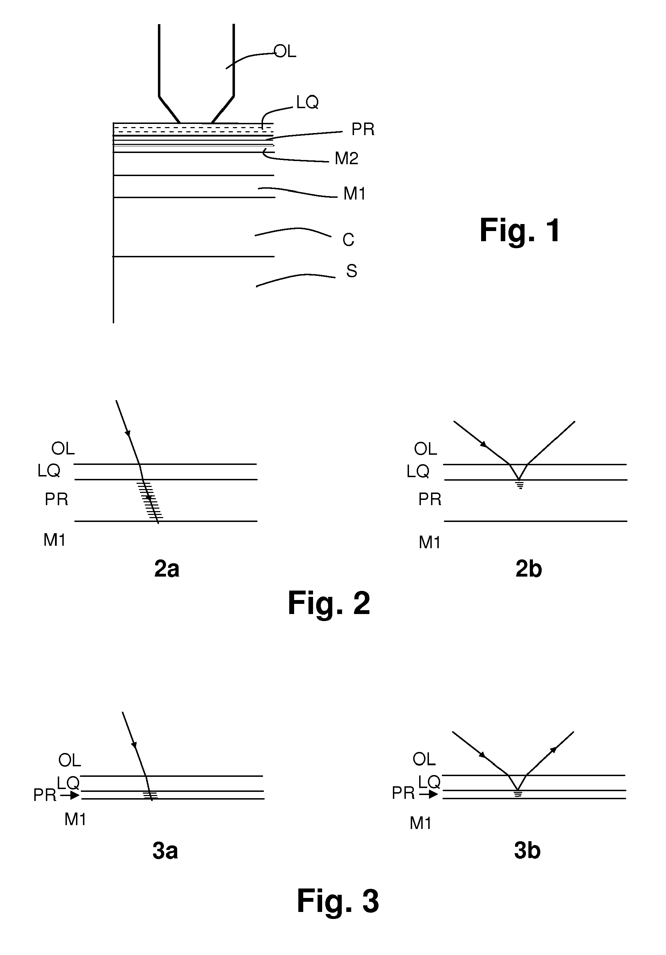

Sur la figure 1, on a représenté schématiquement une optique OL de projection d'image en ultraviolet à une longueur d'onde qui est de préférence de 193 nm mais qui pourrait aussi être à 157 nm. L'image est destinée à exposer une résine photosensible PR qui réagit à cette longueur d'onde. La résine est déposée sur des couches à graver, elles-mêmes déposées sur un substrat plan S.

Pour la lisibilité du schéma, les échelles ne sont pas respectées.

Dans l'exemple représenté, on considère que les couches déposées sur le substrat S comprennent une superposition d'une couche à graver C, d'une première couche M1 qui servira pour les opérations de gravure, d'une deuxième couche M2 qui servira aussi pour les opérations de gravure. On reviendra plus loin sur les raisons de cette superposition. La résine photosensible PR est déposée sur la superposition, donc sur la deuxième couche M2.

L'optique OL comporte classiquement un certain nombre de lentilles non représentées, et elle a une ouverture numérique aussi élevée que possible ; dans la pratique on espère obtenir une ouverture numérique égale ou supérieure à 1,7 en utilisant des matériaux solides d'indice suffisant, transparents à la longueur d'onde utilisée.

Typiquement, on peut utiliser une matière transparente d'indice 2,15 à la longueur d'onde de 193 nanomètres, qui est un grenat d'aluminium-lutetium à structure cubique, pour obtenir alors une optique d'ouverture numérique comprise entre 1,7 et 1,8. La dernière lentille de l'optique OL est réalisée dans ce matériau.

Cette optique n'est pas mise en contact direct avec la couche de résine photosensible, pour ne pas détériorer la résine ou l'optique elle-même. Elle n'est pas non plus séparée par une couche d'air de cette résine, car l'air a un indice de réfraction beaucoup trop faible (environ 1) qui ne permettrait pas de laisser sortir les rayons de forte incidence de l'optique OL.

Un liquide d'immersion LQ est donc interposé entre le verre de la dernière lentille de l'optique OL et la résine photosensible. Ce liquide d'immersion doit être aussi transparent que possible, et par conséquent il est disposé en couche très mince dans le cas (général) où il n'est pas suffisamment transparent. L'ordre de grandeur de l'épaisseur de couche liquide envisagée est de quelques dizaines de micromètres, mais cette épaisseur peut descendre au dessous du micromètre si le coefficient d'absorption optique du liquide à la longueur d'onde considérée est trop fort. Le liquide doit avoir un indice de réfraction supérieur ou égal à l'ouverture numérique de l'optique OL, soit, dans l'exemple donné, supérieur à 1,7 ou 1,8.

On peut utiliser comme liquide d'immersion les liquides suivants:

- mélange $SnCl$, $2H_2O$, glycérol, indice 1,76 dans le visible, plus élevé (environ 1,95) en ultraviolet à 193 nm
- $CH_2I_2$, indice 1,738 dans le visible, plus élevé (environ 1,93) en ultraviolet à 193 nm
- iodure de sodium ou de césium, indice 1,7 à 1,8 dans le visible, plus élevé (environ 2) en ultraviolet à 193 nm
- tribromure d'arsenic, ou mélange à base de tribromure et disulfure d'arsenic en présence de composés de sélénium, indice 2,1 dans le visible, plus élevé (environ 2,3) en ultraviolet à 193 nm (exemple : série H et EH de la société Cargille aux USA).

On utilisera une épaisseur de liquide de 50 micromètres au maximum et de préférence inférieure à 100 nanomètres pour ces liquides qui ont une absorption non négligeable et qui ne sont donc suffisamment transparents qu'à très faible épaisseur.

La résine photosensible PR a un indice de réfraction qui devrait être supérieur à l'ouverture numérique de l'optique.

Malheureusement, on n'a pas trouvé de résine photosensible industriellement utilisable qui aurait un tel indice de réfraction lorsque l'ouverture numérique est très élevée.

La figure 2 représente alors ce qui se passe lorsqu'un rayon lumineux d'incidence moyenne sort de l'optique pour pénétrer dans le liquide d'immersion (figure 2a) et lorsqu'un rayon d'incidence très élevée sort de l'optique pour pénétrer dans le liquide d'immersion (figure 2b). Dans le premier cas (figure 2a), le rayon lumineux peut pénétrer dans la résine et l'exposer sur sa profondeur. Dans le deuxième cas (figure 2b), le rayon lumineux est réfléchi totalement à l'interface liquide d'immersion/résine et n'expose pas la résine.

La théorie montre cependant que dans ce deuxième cas, l'interaction de l'onde électromagnétique lumineuse avec l'interface entre deux couches d'indice de réfraction différentes, produit non seulement une onde réfléchie totalement, qui se propage en sortant du liquide d'immersion, mais aussi une onde stationnaire, qui ne se propage pas et qui est localisée à proximité immédiate de l'interface. Cette onde est appelée onde évanescente, sa particularité étant en effet qu'elle a une amplitude très fortement décroissante avec la profondeur sous l'interface.

L'invention propose de donner à la résine photosensible une épaisseur très faible permettant qu'elle soit exposée par l'onde évanescente même pour les rayons incidents qui produisent une réflexion totale à l'interface entre le liquide d'immersion et la résine. Selon l'invention, on choisit une épaisseur de résine comprise entre 0,1 fois et 0,5 fois la longueur d'onde ultraviolet utilisée. On bénéficie alors de toute la résolution que permet l'utilisation d'une ouverture numérique très élevée de l'optique de projection, sans dégradation due à la réflexion totale des rayons d'incidence très élevée.

Ainsi, en utilisant une résine photosensible normale, ayant un indice de réfraction inférieur à l'ouverture numérique de l'optique, mais en lui donnant une épaisseur comprise entre 0,1 et 0,5 fois la longueur d'onde, on constate que même les rayons d'incidence la plus élevée permettent d'exposer la résine sur toute sa profondeur.

La figure 3, analogue à la figure 2, montre ce qui se passe dans le cas des rayons d'incidence moyenne (figure 3a) et dans le cas de rayons d'incidence très élevée (figure 3b). Dans le premier cas, la résine est exposée par l'onde qui se propage dans la résine après réfraction. Dans le deuxième cas, la résine est exposée par l'onde évanescente qui possède une énergie propre.

La résine ainsi exposée en ultraviolet est ensuite développée pour éliminer les parties non exposées ou les parties exposées selon que la résine est positive ou négative. Le développement laisse subsister des zones de résine qui définissent le motif de gravure. Ces zones protègent les couches sous-jacentes. Un produit d'attaque sélectif, attaquant une couche sous-jacente plus vite que la résine, est utilisé pour graver un motif sous la résine.

Cependant, on comprend que la très faible épaisseur de résine utilisée (par exemple de 20 à 100 nanomètres) va résister plus difficilement aux produits d'attaque que des épaisseurs plus classiques se comptant en centaines de nanomètres. C'est pourquoi il est souhaitable d'utiliser une gravure par transferts successifs de motifs dans plusieurs couches sous-jacentes.

C'est la raison pour laquelle on a représenté à la figure 1 un substrat S recouvert des couches superposées C, M1, M2, la couche C étant la couche à graver finalement avec le motif défini par l'exposition de la résine, et les couches M1 et M2 étant des couches de masquage intermédiaires servant pendant l'opération de gravure.

On va graver d'abord la couche M2, de faible épaisseur, puis utiliser cette couche comme masque de gravure pour graver la couche M1, puis utiliser la couche M1 (ou l'ensemble de M1 et M2) pour graver une couche C située sous la couche M1.

A titre d'exemple, on peut utiliser les couches de masquage suivantes :

- couche M2 en oxyde de silicium de 10 à 20 nanomètres d'épaisseur
- couche M1 dite "couche inerte" en carbone amorphe d'épaisseur environ 100 nanomètres ;

La sélectivité de gravure entre la couche de résine et la couche M2 doit être dans un rapport d'au moins 3 à 5 (rapport de la vitesse de gravure de la couche M2 par rapport à la résine). Avec l'exemple donné ci-dessus (couche M2 en oxyde de silicium de 10 à 20 nanomètres d'épaisseur), on consommera environ 5 nanomètres de résine au maximum pendant la gravure de l'oxyde.

Si la sélectivité de gravure de l'oxyde par rapport à la couche M2 est inférieure à 3, on peut remarquer que la gravure fonctionne quand même si on accepte une certaine dégradation du profil de gravure. L'image transférée dans la couche M2 est alors en quelque sorte une image plus floue que l'image du motif de résine développée après exposition.

Pour la gravure de la couche de carbone M1 en utilisant la couche d'oxyde M2 comme couche de masquage, il est facile de trouver des produits d'attaque présentant une sélectivité élevée, avec une vitesse de gravure de carbone au moins dix fois supérieure à la vitesse de gravure de l'oxyde, et par conséquent la couche M1 peut être beaucoup plus épaisse que la couche M2. Il est important d'avoir une couche M1 suffisamment épaisse pour graver ensuite la couche C.

Si on revient à l'exposition de la résine photosensible PR, et plus particulièrement à l'exposition engendrée par les rayons d'incidence plus élevé que l'angle limite permis par la différence d'indice entre le liquide d'immersion, on peut démontrer par le calcul théorique que l'intensité des ondes évanescentes peut s'écrire sous la forme:

$I = e^{-z/P}$ où z est la variable de profondeur dans la résine à partir de l'interface liquide d'immersion/résine, P est une quantité assimilable à une profondeur et égale à:

$$P = \lambda/[4\pi(n_e^2 \sin^2\theta - n_r^2)^{1/2}]$$

où $\lambda$ est la longueur d'onde, ne est l'indice du liquide d'immersion et $n_r$ celui de la résine, $\theta$ est l'angle d'incidence d'un rayon subissant une réflexion totale.

Par exemple, si l'indice du liquide est 2,1 et l'indice de la résine 1,7 et si la longueur d'onde est de 193 nanomètres et l'angle d'incidence de 60°, l'intensité I s'exprime comme I = e$^{-0,042.z}$ z en nanomètres et on peut évaluer à 25 nanomètres environ la profondeur P jusqu'à laquelle l'énergie des ondes évanescentes peut significativement être utilisée (à la profondeur P, l'énergie est 2,7 fois inférieure à celle qui est présente immédiatement au-dessous de l'interface). Cela veut dire qu'on peut utiliser une couche de résine ayant une épaisseur environ égale à 25 nanomètres si on réussit à l'insoler avec une intensité 2,7 fois plus faible qu'à l'interface. Si on peut choisir un indice de liquide plus proche de celui de la résine, on peut augmenter la quantité P de manière significative.

De préférence, l'épaisseur de la résine est comprise entre 20 et 60 nanomètres.

Un exemple d'appareil de photolithographie utilisant un liquide d'immersion est donné dans la demande de brevet publiée sous le numéro US 2006/072088. Il est utilisable dans le cadre de la présente invention. Il comprend en particulier un système de distribution de ce liquide, qui injecte un liquide entre la surface extérieure de l'optique d'illumination et la surface de la tranche (ou "wafer" en anglais) qui doit subir une gravure. Par surface de la tranche, on entend ici la surface du substrat S recouvert non seulement de la couche à graver C, des couches de masquage M1 et M2, mais aussi de la résine PR. La distance entre la surface extérieure de l'optique et la surface de la tranche est inférieure à 50 micromètres mais peut être beaucoup plus faible (environ 100 nanomètres par exemple) si le liquide d'immersion n'a pas une transparence suffisante pour 50 micromètres. La distribution de fluide se fait si possible tout autour de la tranche pour effectuer une répartition régulière.

La tranche est placée sur une table de positionnement qui permet de la décaler pas-à-pas lorsque l'exposition se fait pas-à-pas.

Un protocole possible d'utilisation du procédé selon l'invention peut consister à déplacer la tranche d'un pas correspondant à l'espacement de deux puces adjacentes sur la tranche, en maintenant un film de liquide d'immersion d'une épaisseur de l'ordre du millimètre entre l'optique de projection et le wafer, avec ou sans renouvellement du fluide. Arrivée en position d'exposition de la puce suivante, la table de positionnement ajuste le plan de la surface de la tranche avec le plan image formé par l'optique de projection. La tranche est ensuite approchée à la distance prévue, inférieure ou égale à 50 micromètres et l'image est exposée aux ultraviolets par l'optique de projection. La circulation du liquide d'immersion peut être interrompue pendant l'étape de rapprochement de la tranche et de l'optique.

La table est ensuite à nouveau abaissée à une distance de l'ordre du millimètre et on recommence l'opération pour une nouvelle exposition de puce.

Un autre protocole possible consiste à positionner l'altitude de la tranche dès la première exposition et à déplacer ensuite la tranche par pas de puce en puce sans changer cette altitude. On le fera avec ou sans renouvellement du liquide d'immersion. Cela suppose évidemment que la distance de travail choisie soit suffisante, entre la tranche et l'optique, pour ne pas risquer qu'un pic de rugosité de la tranche vienne racler l'optique au cours du déplacement. Il faut donc de préférence mesurer au préalable la rugosité de la tranche au moyen d'un rugosimètre, et si possible utiliser des tranches dont la planéité est supérieure à la planéité de tranches traitées selon des procédés standards.

Pour pouvoir utiliser l'invention, il faut que l'image fournie par l'optique de projection OL se forme là où va se trouver la résine photosensible et on doit donc calculer l'optique en fonction de la hauteur de l'espace rempli de liquide d'immersion entre la tranche et l'optique. Une lame à face parallèles peut être rajoutée sous la dernière lentille de l'optique de projection, le choix de son épaisseur permettant de régler la position de l'image formée pour une optique de projection donnée car le déplacement d'image est proportionnel à l'épaisseur de la lame à faces parallèles.

Si l'épaisseur de liquide d'immersion doit varier, il faudra de préférence prévoir des moyens de modification de la position du plan image en correspondance avec la variation désirée. Ces moyens peuvent être mécaniques ou pneumatiques ou électriques.

## Revendications

1.   Procédé de photolithographie pour réaliser un motif gravé dans une couche déposée sur un support, comprenant l'exposition d'une résine photosensible d'indice de réfraction inférieur ou égal à 1,7 par un faisceau de lumière ultraviolette à travers une optique de projection à forte ouverture numérique (supérieure ou égale à 1,7), cette optique comportant une lentille de projection solide à fort indice de réfraction (supérieur à 2), **caractérisé en ce qu'**on interpose entre la lentille et la résine photosensible une couche de liquide d'immersion transparente à la longueur d'onde utilisée, dont l'indice de réfraction pour cette longueur d'onde est supérieur ou égal à l'ouverture numérique de l'optique, et **en ce que** l'indice du liquide d'immersion est supérieur à celui de la résine et l'épaisseur de la résine est comprise entre environ 0,1 et 0,5 fois la longueur d'onde du faisceau d'exposition.

2. Procédé selon la revendication 1, **caractérisé en ce que** le faisceau de lumière est un faisceau ultraviolet à une longueur d'onde de 193 nanomètres ou 157 nanomètres.

3. Procédé selon l'une des revendications 1 et 2, **caractérisé en ce que** la surface de la résine est placée pendant l'exposition à une distance de 100 nanomètres à 50 micromètres de l'optique de projection.

4. Procédé de photolithographie selon l'une des revendications précédentes, **caractérisé en ce que** la résine photosensible est déposée sur des couches de masquage intermédiaires (M1 et M2), elles-mêmes déposées sur une couche (C) à graver selon le motif d'exposition de la résine.

5. Procédé de photolithographie selon la revendication 4, **caractérisé en ce que** la première couche de masquage (M1) déposé sur la couche à graver (C) est une couche de carbone amorphe.

6. Procédé de photolithographie selon l'une des revendications 4 et 5, **caractérisé en ce que** la deuxième couche de masquage (M2) est une couche d'oxyde de silicium mince de 10 à 20 nanomètres d'épaisseur.

OL

LQ

PR

M2

M1

C

S

**Fig. 1**

OL

LQ

PR

M1

**2a**

OL

LQ

PR

M1

**2b**

**Fig. 2**

OL

LQ

PR →

M1

**3a**

OL

LQ

PR →

M1

**3b**

**Fig. 3**

Europäisches
Patentamt

European
Patent Office

Office européen
des brevets

## RAPPORT DE RECHERCHE EUROPEENNE

Numéro de la demande

EP 09 15 1389

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| Y | EP 1 635 382 A (NIPPON KOGAKU KK [JP]) 15 mars 2006 (2006-03-15) * abrégé; figures 1,3,5 * * alinéas [0054], [0114], [0117], [0172], [0176] * | 1-6 | INV. G03F7/20 G03F7/09 |
| Y | US 2006/012885 A1 (BEDER SUSANNE [DE] ET AL) 19 janvier 2006 (2006-01-19) * abrégé; figure 5 * * alinéas [0040], [0061] - [0063], [0066] * | 1-3 | |
| Y | US 2005/233257 A1 (LATCHFORD IAN [US] ET AL LATCHFORD IAN [US] ET AL) 20 octobre 2005 (2005-10-20) * abrégé; figures 2a-2c * * alinéas [0007], [0008], [0047] - [0051] * | 4-6 | |
| A | US 5 121 256 A (CORLE TIMOTHY R [US] ET AL) 9 juin 1992 (1992-06-09) * abrégé; figure 4 * * colonne 2, ligne 55-65 * * colonne 3, ligne 31-33 * * colonne 4, ligne 10-13 * | 1-3 | DOMAINES TECHNIQUES RECHERCHES (IPC) G03F |
| A | US 2004/180299 A1 (ROLLAND JASON P [US] ET AL ROLLAND JASON P [US] ET AL) 16 septembre 2004 (2004-09-16) * abrégé; figures 1,3a,3b * * alinéas [0022] - [0026], [0028], [0033], [0037] * | 1,3,4,6 | |

Le présent rapport a été établi pour toutes les revendications

| Lieu de la recherche | Date d'achèvement de la recherche | Examinateur |
|---|---|---|
| La Haye | 4 mai 2009 | Remy, Jérôme |

CATEGORIE DES DOCUMENTS CITES

X : particulièrement pertinent à lui seul
Y : particulièrement pertinent en combinaison avec un
    autre document de la même catégorie
A : arrière-plan technologique
O : divulgation non-écrite
P : document intercalaire

T : théorie ou principe à la base de l'invention
E : document de brevet antérieur, mais publié à la
    date de dépôt ou après cette date
D : cité dans la demande
L : cité pour d'autres raisons

    & : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 09 15 1389

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

04-05-2009

| Document brevet cité au rapport de recherche | | Date de publication | Membre(s) de la famille de brevet(s) | | Date de publication |
|---|---|---|---|---|---|
| EP 1635382 | A | 15-03-2006 | CN<br>WO<br>KR<br>US<br>US | 1802726 A<br>2004114380 A1<br>20060018869 A<br>2006114445 A1<br>2006132739 A1 | 12-07-2006<br>29-12-2004<br>02-03-2006<br>01-06-2006<br>22-06-2006 |
| US 2006012885 | A1 | 19-01-2006 | US | 2009059385 A1 | 05-03-2009 |
| US 2005233257 | A1 | 20-10-2005 | AUCUN | | |
| US 5121256 | A | 09-06-1992 | AUCUN | | |
| US 2004180299 | A1 | 16-09-2004 | EP<br>JP<br>WO | 1602012 A1<br>2006520104 T<br>2004081666 A1 | 07-12-2005<br>31-08-2006<br>23-09-2004 |

EPO FORM P0460

Pour tout renseignement concernant cette annexe : voir Journal Officiel de l'Office européen des brevets, No.12/82

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20060072088 A